# FASCICULE DE BREVET EUROPEEN

(11) **EP 3 408 799 B1**
(45) Date de publication et mention de la délivrance du brevet: **08.07.2020**
(21) Numéro de dépôt: 17707369.9
(22) Date de dépôt: 25.01.2017
(51) Int. Cl.: G06K 19/077

(54) **PROCÉDÉ DE FABRICATION D'UN MODULE DE CARTE À PUCE ET D'UNE CARTE À PUCE**
VERFAHREN ZUR HERSTELLUNG EINES CHIPKARTENMODULS UND CHIPKARTE
METHOD FOR MANUFACTURING A SMART CARD MODULE AND A SMART CARD

(30) Priorité: 26.01.2016 FR 1650587
(43) Date de publication de la demande: 05.12.2018
(73) Titulaire: Linxens Holding, 78200 Mantes-la-Jolie (FR)
(72) Inventeur: EYMARD, Eric, 43000 Polignac (FR)
(74) Mandataire: GIE Innovation Competence Group
(86) Numéro de dépôt international: PCT/FR2017/050172
(87) Numéro de publication internationale: WO 2017/129904

(56) Documents cités:
- EP-A2- 0 671 705
- WO-A1-2004/107263
- WO-A1-2014/208532

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données d'une puce électronique (circuit intégré) à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention permet de réaliser en particulier des cartes à puce à double interface. De telles cartes sont décrites par exemple dans les documents WO2014/208532A1 et EP0671705A2. Les cartes à puce à double interface sont appelées « dual » (ou « dual interface ») si les modes « avec contact » et « sans contact » sont gérés par une seule puce ou « hybrides » si les modes « avec contact » et « sans contact » sont gérés par deux puces physiquement distinctes, l'une des puces étant connectée aux contacts et l'autre étant connectée à l'antenne. L'invention concerne plutôt les cartes à puce « dual ».

Les cartes à puce à double interface dual sont généralement constituées d'un support rigide en matière plastique de type PVC, PVC/ABS, PET ou polycarbonate constituant l'essentiel de la carte, dans lequel sont incorporés un module électronique et une antenne fabriqués séparément. Le module électronique comporte un circuit imprimé généralement flexible muni d'une puce électronique et de plages de contacts électriquement connectées à des plots de connexion de la puce. Les plages de contacts affleurent sur le module électronique, en surface du support constitutif de la carte, pour une connexion par contact électrique avec un dispositif lecteur de carte. Les cartes à puce à double interface, et notamment « dual », comportent en outre au moins une antenne pour transmettre des données entre la puce et un système radiofréquence permettant la lecture ou l'écriture de données, sans contact.

Dans l'art antérieur, le module électronique comprenant des contacts et la puce, d'une part, et l'antenne éventuellement intégrée à un support (« inlay » selon la terminologie anglo-saxonne) d'autre part, sont généralement fabriqués séparément, puis l'antenne est connectée au module. La connexion entre l'antenne et le module est réalisée selon des procédés complexes qui impactent négativement la productivité, les rendements de fabrication et la fiabilité des cartes lors de leur utilisation.

Un but de l'invention est de simplifier et de fiabiliser ce type de procédés.

Ce but est au moins en partie atteint grâce à un procédé de fabrication d'un module de carte à puce, selon la revendication 1.

Grace à ces dispositions, et notamment au fait qu'après réalisation du module, l'extrémité (appelée ci-dessus « deuxième extrémité ») des fils de connexion entre la puce et l'antenne ne soit pas encapsulée permet de l'utiliser pour établir directement (c'est-à-dire sans autre conducteur, plage de connexion ou conducteur intermédiaire) une connexion avec une plage de connexion de l'antenne. Le procédé selon l'invention apporte donc une simplification par rapport aux procédés de l'art antérieur dans lesquels la deuxième extrémité du fil est reportée sur une piste conductrice, sur la face avant (dite aussi « face contact ») ou sur la face arrière (dite aussi « face bonding »), et dans lesquels cette piste conductrice doit être elle-même connectée, par exemple par soudure et/ou à l'aide d'un autre fil, aux plages de connexion de l'antenne.

Ce procédé de fabrication d'un module de carte à puce comporte éventuellement l'une ou l'autre des caractéristiques suivantes considérées indépendamment des autres ou en combinaison d'une ou plusieurs autres :
- il comporte une étape au cours de laquelle on fixe la deuxième extrémité du fil sur un plot de report, à travers un puits de connexion préalablement réalisé à travers le substrat ; cette disposition permet de maintenir la deuxième extrémité du fil avant que celle-ci ne puisse être maintenue d'une autre manière (par exemple à l'aide d'une couche de matériau thermofusible comme indiqué ci-dessous) ;
- il comporte une étape au cours de laquelle on réalise une découpe autour d'une puce connectée à la première extrémité d'un fil, cette découpe délimitant un module et définissant les dimensions finales du module individualisé, et le puits de connexion dans lequel est fixée la deuxième extrémité du fil se trouvant, après découpe hors du module ; ainsi, le puits de connexion, qui correspond dans ce cas à une structure temporaire, n'apparaît plus sur le produit fini ;
- il comporte une étape au cours de laquelle on applique un matériau thermofusible sur la deuxième face du substrat, de manière à ce que le fil soit accessible sur une portion, et maintenue, sur une autre portion, entre le substrat et le matériau thermofusible ; par exemple on ménage une fenêtre dans le matériau thermofusible, en laissant le fil accessible à travers la fenêtre ; et
- il comporte une étape une étape au cours de laquelle le module est individualisé en le découpant selon ses dimensions finales (c'est-à-dire les dimensions du module lorsqu'il est logé dans une carte), la portion du fil laissée accessible étant alors située sur le module individualisé

Selon un autre aspect, l'invention concerne un procédé de fabrication d'une carte à puce selon la revendication 7.

Ce procédé de fabrication d'une carte à puce comporte éventuellement l'une ou l'autre des caractéristiques suivantes considérées indépendamment des autres ou en combinaison d'une ou plusieurs autres :
- la première extrémité du fil est encapsulée dans une résine d'encapsulation ;
- une portion du fil est maintenue, hors de la résine d'encapsulation, au moins partiellement sur le substrat à l'aide d'un matériau thermofusible ;
- une portion d'un fil connecté à la puce, est soudée à une plage de connexion de l'antenne en appliquant une thermode sur un contact situé sur la première face (face contact) du substrat.

Selon un autre aspect, l'invention concerne un module de carte à puce selon la revendication 11.

Eventuellement, ce module de carte à puce comprend en outre une couche de matériau thermofusible appliquée sur la deuxième face du substrat en laissant au moins une portion du fil découverte par le matériau thermofusible.

Selon un autre aspect, l'invention concerne une carte à puce selon la revendication 13. Eventuellement, la première extrémité du fil est encapsulée avec la puce dans une résine et la portion hors de la résine d'encapsulation est soudée, à travers une ouverture ménagée dans un feuillet thermofusible, à une plage de connexion de l'antenne.

D'autres caractéristiques et avantages de l'invention apparaîtront à la lecture de la description détaillée et des dessins annexés sur lesquels :
- La figure 1 représente schématiquement, en perspective, une carte à puce selon l'invention ;
- La figure 2 représente schématiquement, en perspective et de manière éclatée, la carte à puce de la figure 1 ;
- La figure 3 représente schématiquement, vue de dessus et par la face avant, une portion d'une bande de substrat pour la réalisation de modules de carte à puce telle que celle des figures 1 et 2 ;
- la figure 4 représente schématiquement, en perspective et de manière éclatée, la bande de substrat de la figure 3 vue par la face arrière ; et
- la figure 5 représente schématiquement, en perspective, un module de carte à puce telle que celle des figures 1 et 2.

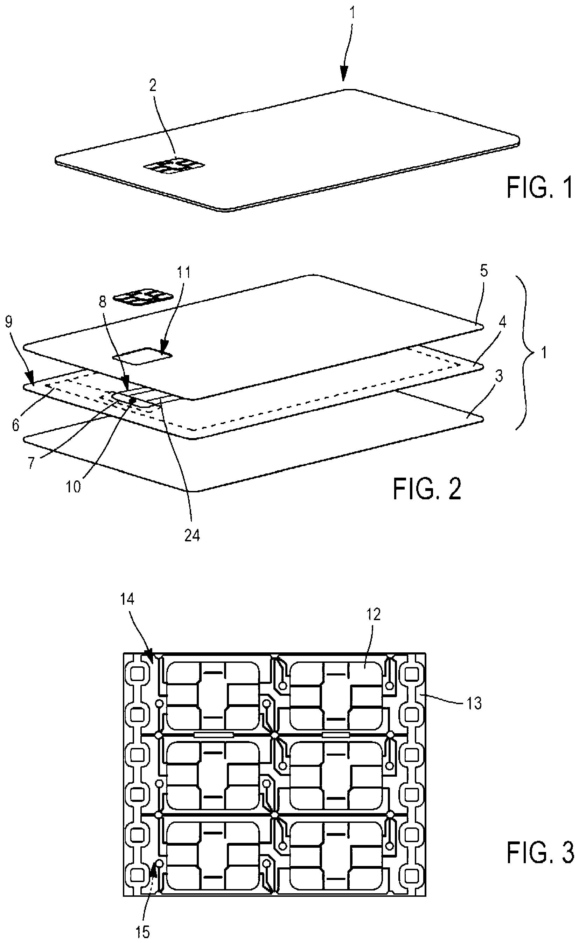

Comme représenté sur la figure 1, une carte à puce 1 comporte un module 2. La carte à puce 1 est constituée de plusieurs couches 3, 4, 5 laminées les unes sur les autres.

Par exemple, la carte à puce montrée sur la figure 2, comporte une couche de finition inférieure 3, un support d'antenne (« inlay ») 4 et une couche de finition supérieure 5.

Les couches de finition inférieure 3 et supérieure 5 peuvent être, par exemple, des couches de PVC imprimées.

Le support d'antenne 4 est généralement lui-même, de manière connue, composée de plusieurs couches entre lesquelles est intégrée une antenne filaire ou gravée dans un feuillet métallique (sur la figure 2, l'antenne 6 insérée entre deux couches est représentée en traits pointillés). Les différentes couches constitutives du support d'antenne 4 sont par exemple également réalisées en PVC.

L'antenne 6 comporte par exemple une ligne conductrice enroulée sur plusieurs boucles s'étendant en périphérie de la carte 1. Chacune des deux extrémités de la ligne est reliée à une plage de connexion 7. Les plages de connexion 7 sont au moins en partie apparentes et accessibles au niveau d'une ouverture 8 ménagée dans une couche supérieure 9 du support d'antenne 4. Les plages de connexion 7 comportent par exemple des plots de soudure 10. Les plots de soudure 10 sont constitués d'un matériau ayant une température de fusion comprise entre 120°C et 230°C, et plus préférentiellement entre 160°C et 190°C.

Lors de la mise en oeuvre du procédé de fabrication de la carte à puce 1, les couches de finition inférieure 3, supérieure 5 et le support d'antenne 4 sont laminés ensemble, puis une cavité 11 est fraisée dans la couche de finition supérieure 5, pour pouvoir y loger un module 2 et pour mettre à nu les plages de connexion 7 de l'antenne 6, munies chacune respectivement d'un plot de soudure 10.

Par ailleurs, le procédé de fabrication du module 2 comporte la réalisation de contacts 12 métalliques sur un substrat 13 flexible (voir figure 3). Le substrat 13 comporte une première 14 et une deuxième 15 faces principales, avec les contacts 12 sur la première face 14 du substrat 13 (face avant ou face contact).

Ces contacts 12 sont réalisés par exemple de manière connue par gravure d'un feuillet métallique (ex : alliage de cuivre) supporté par un substrat diélectrique (ex : verre epoxy) ou par découpe de motifs métalliques et report de ces motifs sur un substrat diélectrique (technologie dite « leadframe »).

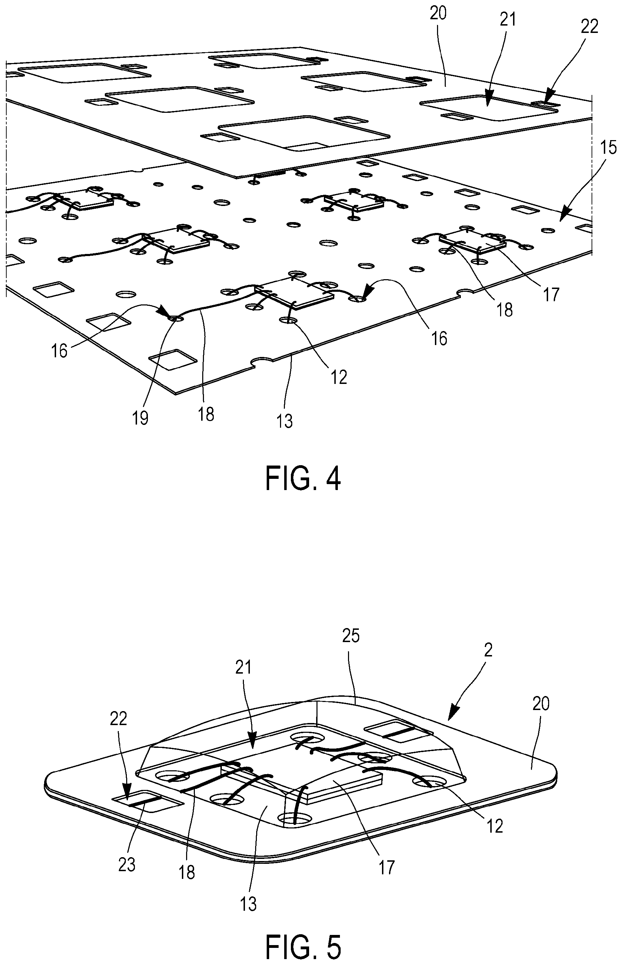

Comme représenté sur la figure 4, le substrat 13 est perforé pour réaliser des puits de connexion 16 dont le fond est obturé par les contacts 12. Des puces 17 (une par module) sont collées en face arrière 15 du substrat 13 (face bonding). Chaque puce 17 est connectée à l'aide de fils conducteurs 18 reliant, à travers les puits de connexion 16, des contacts 12 à des plots de connexion de la puce 17.

En outre, deux plots de connexion de la puce sont reliés, également par des fils 18 traversant des puits de connexion 16, chacun respectivement à un plot de report 19. Chaque plot de report 19 est réalisé de manière semblable aux contacts 12 et simultanément avec ceux-ci. Les fils 18 de connexion de la puce 17 à l'antenne 6 sont donc chacun reliés par une première extrémité à la puce 17 et par une deuxième extrémité à un plot de report 19.

Une couche de matériau thermofusible 20 dans laquelle sont ménagées des ouvertures 21, 22 est ensuite appliquée sur la face arrière 15 du substrat 13. Cette couche de matériau thermofusible 20 permet de fixer le module 2 dans sa cavité 11 fraisée dans la carte 1. Les ouvertures 21, 22 sont de deux types: de grandes ouvertures 21 dans lesquelles viennent prendre place les puces 17 et les fils de connexion 18 de la puce 17 aux contacts 12, et des fenêtres 22 plus petites, à travers chacune desquelles un fil de connexion 18 de la puce 17 à l'antenne 6 reste apparent et accessible. Chacune de ces fenêtres 22 est traversée par une portion 23 du fil 18 de connexion de la puce 17 à l'antenne 7 (Voir FIG. 5). Cette portion 23 du fil 18 est maintenue sur deux côtés opposés de chaque fenêtre 22, entre le matériau thermofusible 20 et le substrat 13. La portion 23 du fil 18 traversant chaque fenêtre 22 est relativement libre. Elle est étendue sur la surface du substrat 13 sans y adhérer.

Une résine 25 d'encapsulation recouvre la puce 17 et les fils 18 de connexion de la puce 17 aux contacts 12. La goutte de résine 25 d'encapsulation se trouve circonscrite par le bord des grandes ouvertures 21. Les fenêtres 22 à travers lesquelles passe une portion 23 des fils 18 de connexion de la puce 17 à l'antenne 6, sont dépourvues de résine 25.

Sur le module 2 fini et individualisé, la couche de matériau thermofusible 20 forme un cadre tout autour de la puce 17. Seules deux fenêtres 23 sont découpées dans ce cadre. Les dimensions de ces fenêtres 23 sont relativement faibles (par exemple 1mmx2mm). Ainsi, la présence de ces fenêtres 23 n'a pratiquement pas d'influence sur l'adhésion du module 2 sur des rebords 24 réalisées lors du fraisage de la cavité 11 de la carte 1 (Voir FIG. 2).

Après découpe du module 2 ainsi individualisé dans ses dimensions finales, les puits de report 19 auxquels étaient reliées les deuxièmes extrémités des fils 18 de connexion de la puce 17 à l'antenne 6, ont été éliminés.

Le module 2 est ensuite reporté dans une cavité 11 fraisée dans une carte à puce 1. Les fenêtres 23 traversées par les fils 18 de connexion de la puce 17 à l'antenne 6 sont placées en vis-à-vis des plages de connexion 7 de l'antenne 6 laissées apparentes dans la cavité 11.

Une thermode (non-représentée) est appliquée sur la face contact 14 du module 2. La chaleur fournie par la thermode réactive le matériau thermofusible 20 situé en face arrière 15 du module 2. Le matériau thermofusible 20 adhère à des rebords 24 créés dans la cavité 11 lors de son fraisage. Par ailleurs, la thermode fait fondre les plots de soudure 10 placés sur les plages de connexion 7 de l'antenne 6. La thermode est par exemple chauffée à une température comprise entre 120°C et 250°C. La conduction de la chaleur entre la thermode et le plot de soudure 10 est particulièrement efficace puisqu'elle se fait seulement à travers les contacts 12 qui sont bon conducteurs thermiques et le substrat 13.

La soudure fondue des plots de soudure 10 vient au contact de la portion 23 de fil 18 traversant chaque fenêtre 22. La portion 23 de fil 18 ainsi en partie enrobée de soudure est alors électriquement connectée à l'antenne 6. En outre, la soudure n'adhérant pas au substrat 13 ou au matériau thermofusible 20, la portion 23 de fil 18 prise dans la soudure est solidaire des plots de connexion 7 de l'antenne 6, mais conserve une relative liberté de déplacement par rapport au module 2. Cette relative liberté de déplacement et les propriétés d'élongation du fil 18 permettent de compenser les mouvements du module 2 par rapport au reste du corps de la carte 1, et d'absorber les contraintes générées entre eux, lors de l'utilisation de cette dernière, et évitent les déconnexions accidentelles de l'antenne 6 parfois constatées dans les cartes de l'art antérieur.

## Revendications

1. Procédé de fabrication d'un module (2) de carte à puce (1), dans lequel
- on fournit un substrat (13) ayant une première (14) et une deuxième (15) faces principales, avec sur la première face (14) du substrat (13), des contacts (12) pour une connexion électrique temporaire avec un dispositif de lecture de carte à contacts,
- on attache une puce électronique (17) au substrat (13),
- on connecte directement au moins un fil (18), par une première extrémité, sur un plot de connexion de la puce (17), et on encapsule la puce (17) et la première extrémité dudit fil (18) dans une résine (25),
**caractérisé par le fait que** ledit fil (18) est destiné à établir directement une connexion entre la puce électronique (17) et une antenne (6) et qu'on laisse une deuxième extrémité dudit fil (18), hors de la résine (25).

2. Procédé selon la revendication 1, comportant une étape au cours de laquelle on fixe la deuxième extrémité dudit fil (18) sur un plot de report (19), à travers un puits de connexion (16) préalablement réalisé à travers le substrat (13).

3. Procédé selon la revendication 2, dans lequel on réalise une découpe autour de la puce (17) connectée à la première extrémité dudit fil (18), cette découpe délimitant un module (2) et définissant les dimensions finales du module (2) individualisé, et le puits de connexion (16) dans lequel est fixée la deuxième extrémité dudit fil (18) se trouvant, après découpe hors du module (2).

4. Procédé selon l'une des revendications précédentes, comportant une étape au cours de laquelle on applique un matériau thermofusible (20) sur la deuxième face (15) du substrat (13), de manière à ce que ledit fil (18) soit accessible sur une portion (23), et maintenue, sur une autre portion, entre le substrat (13) et le matériau thermofusible (20).

5. Procédé selon la revendication 4, dans lequel une fenêtre (23) a été ménagée dans le matériau thermofusible (20), en laissant ledit fil (18) accessible à travers la fenêtre (23).

6. Procédé selon la revendication 4 ou 5, comportant une étape au cours de laquelle le module (2) est individualisé en le découpant selon ses dimensions finales, la portion (23) dudit fil (18) laissée accessible étant alors située sur le module (2) individualisé.

7. Procédé de fabrication d'une carte à puce (1) comprenant
- la réalisation d'un module (2) conformément au procédé selon l'une des revendications 1 à 6, ce module comportant un substrat (13) ayant une première (14) et une deuxième (15) faces principales, avec sur la première face (14) du substrat (13), des contacts (12) pour une connexion électrique temporaire avec un dispositif de lecture de carte à contacts, et comportant une puce (17) électronique attachée au substrat (13),
- la réalisation d'une antenne (6) sur un support (4), cette antenne (6) comprenant deux extrémités, chacune munie d'une plage de connexion (7),
- la réalisation d'une cavité (11) dans au moins une couche (5) de la carte (1) recouvrant au moins partiellement le support (4), pour loger le module (2) et rendre apparentes les plages de connexion (7) de l'antenne (6),
dans lequel une portion (23) dudit fil (18) est connectée, directement à une plage de connexion (7) de l'antenne (6).

8. Procédé selon la revendication 7, dans lequel la première extrémité dudit fil (18) est encapsulée dans une résine (25) d'encapsulation.

9. Procédé selon la revendication 8, dans lequel une portion (23) dudit fil (18), est maintenue, hors de la résine (25) d'encapsulation, au moins partiellement sur le substrat (13), à l'aide d'un matériau thermofusible (20).

10. Procédé selon l'une des revendications 7 à 9, dans lequel une portion (23) dudit fil (18) connecté à la puce (17), est soudée à une plage de connexion (7) de l'antenne (6) en appliquant une thermode sur un contact (12) situé sur la première face (14) du substrat (13).

11. Module de carte à puce comprenant
- un substrat (13) ayant une première (14) et une deuxième (15) faces principales, avec sur la première face (14) du substrat (13), des contacts (12) pour une connexion électrique temporaire avec un dispositif de lecture de carte à contacts,
- une puce électronique (17) fixée au substrat (13),
- au moins un fil (18) connecté par une première extrémité, sur un plot de connexion de la puce (17),
dans lequel la puce (17) et la première extrémité dudit fil (18) sont encapsulées dans une résine (25),
**caractérisé par le fait que** ledit fil (18) est destiné à établir directement une connexion entre la puce électronique (17) et une antenne (6) et qu'une portion (23) dudit fil (18) s'étend hors de la résine (25).

12. Module selon la revendication 11, comprenant une couche de matériau thermofusible (20) appliquée sur la deuxième face (15) du substrat (13) en laissant au moins une portion (23) dudit fil (18) découverte par le matériau thermofusible (20).

13. Carte à puce comprenant un module (2) selon l'une des revendications 11 et 12, avec une puce (17), et une antenne (6), ledit module comportant au moins un fil (18) ayant une première extrémité connectée directement sur un plot de connexion de la puce (17) et une portion (23) connectée directement sur une plage de connexion (7) de l'antenne (6).

14. Carte à puce selon la revendication 13, dans laquelle la première extrémité dudit fil (18) est encapsulée avec la puce (17) dans une résine (25) et une portion (23) hors de la résine (25) d'encapsulation est soudée, à travers une ouverture (22) ménagée dans un feuillet thermofusible (20), à une plage de connexion (7) de l'antenne (6).

## Patentansprüche

1. Verfahren zur Herstellung eines Moduls (2) einer Chipkarte (1), wobei
- ein Substrat (13) bereitgestellt wird, das eine erste (14) und eine zweite (15) Hauptseite aufweist, mit Kontakten (12) für eine zeitweilige elektrische Verbindung mit einer Kartenlesevorrichtung mit Kontakten auf der ersten Seite (14) des Substrats (13),
- ein Mikrochip (17) an dem Substrat (13) angebracht wird,
- wenigstens ein Draht (18) mit einem ersten Ende direkt an ein Anschlusspad des Chips (17) angeschlossen wird und der Chip (17) und das erste Ende des Drahtes (18) in einem Harz (25) verkapselt werden,
**dadurch gekennzeichnet, dass** der Draht (18) dazu bestimmt ist, direkt eine Verbindung zwischen dem Mikrochip (17) und einer Antenne (6) herzustellen, und dass ein zweites Ende des Drahtes (18) außerhalb des Harzes (25) gelassen wird.

2. Verfahren nach Anspruch 1, welches einen Schritt umfasst, in welchem das zweite Ende des Drahtes (18) durch eine Anschlussbuchse (16) hindurch, die zuvor durch das Substrat (13) hindurch ausgebildet wurde, an einem Übertragungskontakt (19) befestigt wird.

3. Verfahren nach Anspruch 2, wobei ein Ausschnitt um den Chip (17) herum hergestellt wird, der mit dem ersten Ende des Drahtes (18) verbunden ist, wobei dieser Ausschnitt ein Modul (2) begrenzt und die endgültigen Abmessungen des vereinzelten Moduls (2) definiert, und wobei die Anschlussbuchse (16), in welcher das zweite Ende des Drahtes (18) befestigt wird, sich nach dem Ausschneiden außerhalb des Moduls (2) befindet.

4. Verfahren nach einem der vorhergehenden Ansprüche, welches einen Schritt umfasst, in welchem ein wärmeschmelzbares Material (20) auf die zweite Seite (15) des Substrats (13) aufgebracht wird, derart, dass der Draht (18) auf einem Abschnitt (23) zugänglich ist und auf einem anderen Abschnitt zwischen dem Substrat (13) und dem wärmeschmelzbaren Material (20) gehalten wird.

5. Verfahren nach Anspruch 4, wobei ein Fenster (23) in dem wärmeschmelzbaren Material (20) ausgebildet worden ist, wobei der Draht (18) durch das Fenster (23) hindurch zugänglich gelassen wird.

6. Verfahren nach Anspruch 4 oder 5, welches einen Schritt umfasst, in welchem das Modul (2) vereinzelt wird, indem es gemäß seinen endgültigen Abmessungen ausgeschnitten wird, wobei sich der zugänglich gelassene Abschnitt (23) des Drahtes (18) dann auf dem vereinzelten Modul (2) befindet.

7. Verfahren zur Herstellung einer Chipkarte (1), welches umfasst:
- die Herstellung eines Moduls (2) gemäß dem Verfahren nach einem der Ansprüche 1 bis 6, wobei dieses Modul ein Substrat (13) aufweist, das eine erste (14) und eine zweite (15) Hauptseite aufweist, mit Kontakten (12) für eine zeitweilige elektrische Verbindung mit einer Kartenlesevorrichtung mit Kontakten auf der ersten Seite (14) des Substrats (13), und einen Mikrochip (17) aufweist, der an dem Substrat (13) angebracht ist,
- die Herstellung einer Antenne (6) auf einem Träger (4), wobei diese Antenne (6) zwei Enden umfasst, die jeweils mit einem Anschlussbereich (7) versehen sind,
- die Herstellung eines Hohlraums (11) in wenigstens einer Schicht (5) der Karte (1), die den Träger (4) wenigstens teilweise bedeckt, um das Modul (2) aufzunehmen und die Anschlussbereiche (7) der Antenne (6) sichtbar zu machen,
wobei ein Abschnitt (23) des Drahtes (18) direkt an einen Anschlussbereich (7) der Antenne (6) angeschlossen wird.

8. Verfahren nach Anspruch 7, wobei das erste Ende des Drahtes (18) in einem Vergussharz (25) verkapselt wird.

9. Verfahren nach Anspruch 8, wobei ein Abschnitt (23) des Drahtes (18) außerhalb des Vergussharzes (25) mithilfe eines wärmeschmelzbaren Materials (20) wenigstens teilweise auf dem Substrat (13) gehalten wird.

10. Verfahren nach einem der Ansprüche 7 bis 9, wobei ein Abschnitt (23) des Drahtes (18), der mit dem Chip (17) verbunden ist, an einen Anschlussbereich (7) der Antenne (6) angeschweißt wird, indem eine Thermode an einen Kontakt (12) angelegt wird, der sich auf der ersten Seite (14) des Substrats (13) befindet.

11. Chipkartenmodul, welches umfasst:
- ein Substrat (13), das eine erste (14) und eine zweite (15) Hauptseite aufweist, mit Kontakten (12) für eine zeitweilige elektrische Verbindung mit einer Kartenlesevorrichtung mit Kontakten auf der ersten Seite (14) des Substrats (13),
- einen Mikrochip (17), der an dem Substrat (13) befestigt ist,
- wenigstens einen Draht (18), der mit einem ersten Ende an ein Anschlusspad des Chips (17) angeschlossen ist,
wobei der Chip (17) und das erste Ende des Drahtes (18) in einem Harz (25) verkapselt sind,
**dadurch gekennzeichnet, dass** der Draht (18) dazu bestimmt ist, direkt eine Verbindung zwischen dem Mikrochip (17) und einer Antenne (6) herzustellen, und dass sich ein Abschnitt (23) des Drahtes (18) außerhalb des Harzes (25) erstreckt.

12. Modul nach Anspruch 11, welches eine Schicht aus wärmeschmelzbarem Material (20) umfasst, die auf die zweite Seite (15) des Substrats (13) aufgebracht ist, wobei wenigstens ein Abschnitt (23) des Drahtes (18) von dem wärmeschmelzbaren Material (20) unbedeckt gelassen ist.

13. Chipkarte, welche ein Modul (2) nach einem der Ansprüche 11 und 12 mit einem Chip (17) und eine Antenne (6) umfasst, wobei das Modul wenigstens einen Draht (18) umfasst, der ein erstes Ende, das direkt an ein Anschlusspad des Chips (17) angeschlossen ist, und einen Abschnitt (23), der direkt an einen Anschlussbereich (7) der Antenne (6) angeschlossen ist, aufweist.

14. Chipkarte nach Anspruch 13, wobei das erste Ende des Drahtes (18) mit dem Chip (17) in einem Harz (25) verkapselt ist und ein Abschnitt (23) außerhalb des Vergussharzes (25) durch eine Öffnung (22) hindurch, die in einem wärmeschmelzbaren Plättchen (20) ausgebildet ist, an einen Anschlussbereich (7) der Antenne (6) angeschweißt ist.

## Claims

1. Method for producing a chip card (1) module (2), in which:
- a substrate (13) having a first (14) main face and a second (15) main face is provided, with contacts (12) on the first face (14) of the substrate (13) for making a temporary electrical connection with a contact card reader device;
- an electronic chip (17) is attached to the substrate (13);
- a first end of at least one wire (18) is connected directly to a connection pad of the chip (17), and the chip (17) and the first end of said wire (18) are encapsulated in a resin (25),
**characterized in that** said wire (18) is intended to make a connection directly between the electronic chip (17) and an antenna (6) and that a second end of said wire (18) is left outside the resin (25).

2. Method according to Claim 1, comprising a step in which the second end of said wire (18) is fixed to a transfer pad (19) through a connection well (16) previously made through the substrate (13).

3. Method according to Claim 2, in which a cut is made around the chip (17) connected to the first end of said wire (18), this cut delimiting a module (2) and defining the final dimensions of the singulated module (2), and the connection well (16), in which the second end of said wire (18) is fixed, being located outside the module (2) after cutting.

4. Method according to one of the preceding claims, comprising a step in which a hot-melt material (20) is applied to the second face (15) of the substrate (13), such that one portion (23) of said wire (18) is accessible and another portion is held between the substrate (13) and the hot-melt material (20).

5. Method according to Claim 4, in which a window (23) has been made in the hot-melt material (20), leaving said wire (18) accessible through the window (23).

6. Method according to Claim 4 or 5, comprising a step in which the module (2) is singulated by dicing it according to its final dimensions, the portion (23) of said wire (18) that is left accessible being then located on the singulated module (2).

7. Method for producing a chip card (1) comprising:
- the production of a module (2) in accordance with the method according to one of Claims 1 to 6, this module comprising a substrate (13) having a first (14) main face and a second (15) main face, with contacts (12) for making a temporary electrical connection with a contact card reader device on the first face (14) of the substrate (13), and comprising an electronic chip (17) attached to the substrate (13);
- the production of an antenna (6) on a carrier (4), this antenna (6) comprising two ends, each equipped with a connection land (7);
- the production of a cavity (11) in at least one layer (5) of the card (1) at least partially covering the carrier (4), in order to house the module (2) and to expose the connection lands (7) of the antenna (6),
in which a portion (23) of said wire (18) is connected directly to a connection land (7) of the antenna (6).

8. Method according to Claim 7, in which the first end of said wire (18) is encapsulated in an encapsulation resin (25).

9. Method according to Claim 8, in which a portion (23) of said wire (18) is held, outside the encapsulation resin (25), at least partially on the substrate (13) using a hot-melt material (20).

10. Method according to one of Claims 7 to 9, in which a portion (23) of said wire (18) connected to the chip (17) is soldered to a connection land (7) of the antenna (6) by applying a thermode to a contact (12) located on the first face (14) of the substrate (13).

11. Chip card module comprising:
- a substrate (13) having a first (14) main face and a second (15) main face, with contacts (12) on the first face (14) of the substrate (13) for making a temporary electrical connection with a contact card reader device;
- an electronic chip (17) fixed to the substrate (13);
- at least one wire (18) connected, by a first end, to a connection pad of the chip (17),
in which the chip (17) and the first end of said wire (18) are encapsulated in a resin (25),
**characterized in that** said wire (18) is intended to make a connection directly between the electronic chip (17) and an antenna (6) and that a portion (23) of said wire (18) extends out of the resin (25).

12. Module according to Claim 11, comprising a layer of hot-melt material (20) applied to the second face (15) of the substrate (13) while leaving at least one portion (23) of said wire (18) uncovered by the hot-melt material (20).

13. Chip card comprising a module (2) according to either of Claims 11 and 12, with a chip (17), and an antenna (6), said module comprising at least one wire (18) having a first end connected directly to a connection pad of the chip (17) and a portion (23) connected directly to a connection land (7) of the antenna (6).

14. Chip card according to Claim 13, in which the first end of said wire (18) is encapsulated, with the chip (17), in a resin (25) and a portion (23) outside the encapsulation resin (25) is soldered, through an opening (22) made in a hot-melt sheet (20), to a connection land (7) of the antenna (6).
